# EUROPEAN PATENT SPECIFICATION

(11) **EP 0 265 135 B1**
(45) Date of publication and mention of the grant of the patent: **22.12.1993**
(21) Application number: 87308997.3
(22) Date of filing: 12.10.1987
(51) Int. Cl.: G03F 7/00

(54) **Antistatic photo-resist**
Antistatischer Photolack
Photoréserve antistatique

(30) Priority: 13.10.1986 JP 242793/86
(43) Date of publication of application: 27.04.1988
(73) Proprietor: MITSUBISHI DENKI KABUSHIKI KAISHA, Tokyo 100 (JP); MITSUBISHI KASEI CORPORATION, Tokyo 100 (JP)
(72) Inventor: Miura, Konoe, Yokohama-shi Kanagawa-ken (JP); Ochiai, Tameichi, Sagamihara-shi Kanagawa-ken (JP); Kameyama, Yasuhiro, Machida-shi Tokyo (JP); Koyama, Tooru c/o Mitsubishi Denki K.K., Itami-shi Hyogo-ken (JP); Okabe, Takashi c/o Mitsubishi Denki K.K., Itami-shi Hyogo-ken (JP); Mametani, Tomoharu c/o Mitsubishi Denki K.K., Itami-shi Hyogo-ken (JP)
(74) Representative: Woods, Geoffrey Corlett

(56) References cited:
- EP-A- 0 182 587
- DE-A- 2 028 214
- FR-A- 2 354 578
- NL-A- 8 000 312
- US-A- 4 196 003

## Description

The present invention relates to a photo-resist for use as a mask in ion implantation of a semiconductor substrate.

The introduction of an impurity is indispensable in the production of a semiconductor. Hitherto, a method of thermal dispersion has been mainly employed in the introduction of the impurity. In recent years, however, the so-called ion implantation method has come to be mainly employed. In this method, the ions of substance to be introduced are electrostatically accelerated and implanted into a solid body. Control of this method is easy.

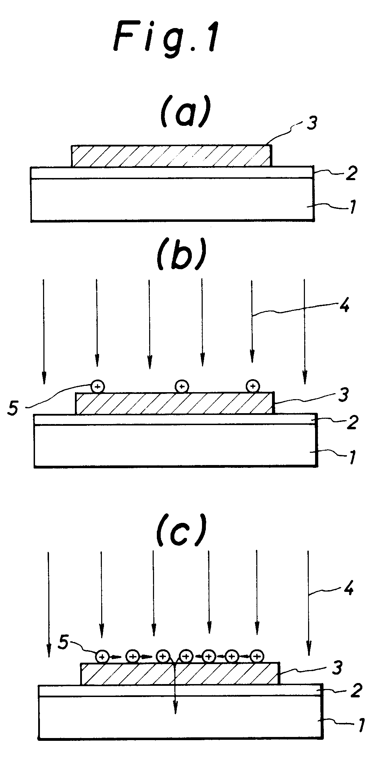

Since the impurity can be doped at a low temperature by this method, it has become possible to use the photo-resist as a mask in doping. However, the following demerit has been observed in using the photoresist as the mask in doping. Namely, in the case where ions are implanted part by to the substrate, the ion implantation is carried out after forming the pattern of the photo-resist on the part to which the ions are not to be implanted for the purpose of masking. However, the photo-resist generally comprises a high polymeric substance and is non-electroconductive. Accordingly, the surface of the photo-resist is electrically charged during the ion implantation. The amount of electrical charge increases with the increase of electrical current for ion implantation, and the resulting charge causes dielectric breakdown of the insulating membrane, such as the silicon oxide membrane under the photo-resist. Fig. 1 shows the process of dielectric breakdown in the ion implantation. In Fig. 1(a) an oxide membrane(2) is grown on a silicon substrate (1) and a photo-resist(3) is patterned on the oxide membrane(2). Fig. 1(b) shows the manner of implantation of the ions (4).

Since the ions to be implanted are positively charged, the surface of the photo-resist is positively charged(5). Fig. 1(c) shows that the amount of electrical charge on the surface of the photo-resist increases causing dielectric breakdown of the silicon oxide membrane.

The electrical charge on the surface of the photo-resist at the time of ion implantation has an undesirable effect on the uniformity of the ion implantation to the substrate even though the electrical charge does not cause dielectric breakdown of the insulating membrane under the patterned photo-resist. According to the electrical field caused by the electrical charge on the surface of the photo-resist, the ion beam bends, and accordingly the amount of implanted ions is a minimum at the central part of the substrate and becomes larger toward the peripheral parts.

As is shown above, in the conventional ion implantation method, the surface of the patterned photo-resist is electrically charged, and as a result there have been problems such as the occurrence of dielectric breakdown in the insulating membrane under the patterned photo-resist and/or the inequality of the amount of implanted ions to the substrate.

Since the above-mentioned problems become remarkable with the increase of the amount of electric current for implanting the ions, the amount of electrical current for implanting the ions has up until now been kept low, and time for the ion implantation could not be reduced. Additionally, with the miniaturization of electric elements, the thickness of the insulating membrane such as the silicon oxide membranes is reduced and accordingly the breakdown voltage becomes lower. In such a situation, the dielectric breakdown in the insulating membrane at the time of the ion implantation is important.

At present, as a method of reducing the electric charge on the surface of the photo-resist pattern at the time of implanting the ions, electrons are supplied to the vicinity of the surface of the substrate to neutralize the electrical charge. However, in this method it is difficult to supply the optimum amount of electrons to the ion implantation apparatus.

We have found that the above problems can be overcome by using a photo-resist containing certain antistatic agents.

The present invention provides a photo-resist for use as a mask in ion implantation of a semiconductor substrate, which comprises an antistatically effective amount of an anti-static agent, said anti static agent being:
i) a substance having an ionization potential of not larger than 7.5 eV and being ethylcarbazole, or a derivative of pyrazoline, oxadiazole or hydrazone or p-bis(dimethylamino)benzene; or
ii) an organic conductor of a charge-transfer complex type comprising a donor which is tetrathiafulvalene,a condensed-polynuclear aromatic compound, an aromatic amine selected from p-diaminobenzene, 4,4'-bis(dimethylamino)biphenyl and naphthylamine, or dibenzopyrazine and an acceptor which is a polycyano compound, a quinone derivative or a polynitro compound.

The present invention also provides a method of producing a semiconductor substrate implanted with ions by applying a photo-resist on to a semiconductor substrate, patterning the photo-resist and effecting ion implantation, wherein the photo-resist is as defined above.

In the attached drawing, Fig. 1 shows the process of the dielectric breakdown. In Fig. 1, 1 is a silicon substrate, 2 is an oxide membrane, 3 is a photo-resist and 4 is an ion beam.

Hitherto, the surface resistance of a photo-resist used at the time of ion implantation was greater than 10¹⁴ Ω. This high insulating property is the main reason for dielectric breakdown of the insulating membrane. The present inventors have found that by adding a particular antistatic agent to the photo-resist, the surface resistance is reduced and dielectric breakdown, for example, can be prevented.

The antistatic agent fulfills the following conditions:
(1) it has compatibility with the photo-resist composition or can be uniformly dispersed therein;
(2) it does not contain ions and elements which undesirably influence the performance of the electric element produced. More precisely, the antistatic agent does not contain any alkali metal ions halogen ions or heavy metals;
(3) it does not substantially reduce the sensitivity of the photo-resist to light. More precisely, the antistatic agent does not absorb much of the light at the wavelength at which the photo-resist absorbs the light; and
(4) it does not reduce the resolving power of the photo-resist.

Preferred anti-static agents (i) have an ionization potential of not larger than 7.0 eV to make conduction of a hole possible.

An example of an anti-static agent (ii) is a complex of tetrathiafulvalene (TTF) as a donor with tetracyanoquinodimethane(TCNQ) as an accepter (a so-called TTF-TCNQ complex). Examples of the condensed-polynuclear aromatic compounds used as donors are chrysene and pyrene. An example of the polycyano compound used as the acceptor is tetracyanoethane; examples of the quinone derivatives are chloranil, bromanil, fluoranil and dicyanodichloroquinone; and an example of the polynitro compound is trinitrobenzene. Of the above charge-transfer complexes, TTF-TCNQ is preferred.

For anti-static agents (i), an example of a derivative of hydrazone is p-dimethylaminobenzaldehyde diphenylhydrazone. Derivatives of hydrazone and the aromatic amines are preferred anti-static agents (ii).

The antistatic agent may be used in any amount so long as a sufficient antistatic effect is obtained and the original properties of the photo-resist are not deteriorated; The amount is preferably 0.1 to 15 wt%, more preferably 0.5 to 10 wt%, based on the solid content of the photo-resist.

As the photo-resist to which the antistatic agent is added, a positive-type photo-resist which is obtained by combining a photosensitizer of naphthoquinone diazides with a novolac resin formed by polycondensing a hydroxyaromatic compound such as phenol, cresol, ethylphenol, t-butylphenol, xylenol, naphthol, 1,4-dihydroxybenzene or 1,3-dihydroxybenzene, or a mixture thereof, with, an aldehyde such as formaldehyde, acetaldehyde, benzaldehyde or furfural; polyhydroxystyrene or a derivative thereof and a negative-type photo-resist which is obtained by combining a photosensitizer of azides with a resin of cyclized rubber are generally used. A positive-type photo-resist comprising a novolac resin and a photosensitizer is preferred.

Although the photosensitizer of naphthoquinone diazides is not particularly limited, the compounds disclosed in J. Kosar, "Light-sensitive Systems", John Wiley & Sons, Inc, 343 - 351 may particularly be mentioned. Preferred photosensitizers are esters of 1,2-benzoquinonediazide-4-sulfonic acid, esters of 1,2-naphthoquinonediazide-5-sulfonic acid and esters of 1,2-naphthoquinondiazide-4-sulfonic acid. More preferably an ester of a polyhydroxy aromatic compound with 1,2-naphthoquinonediazide-5-sulfonic acid or 1,2-naphthoquinonediazide-4-sulfonic acid is used. Preferred polyhydroxy aromatic compounds are 2,3,4-trihydroxybenzophenone, 2,3,4,4'-tetrahydroxybenzophenone and quercetin.

The present inventors have formerly proposed several examples of a positive-type photo-resist comprising novolac resin and a photosensitizer (JP-A-58-150035(1983), JP-A-58-158301(1983), JP-A-59-12792(1984), JP-A-59-30097(1984) and JP-A-60-25660(1985)).

The mixing amount of the photosensitizer of naphthoquinonediazides is preferably 5 to 100 parts by weight of the novolac resin.
Usually these components are used by dissolving them in a suitable solvent. There is no limit on the solvent so long as it has a sufficient dissolving power for the photosensitizer and novolac resin and gives a favorable coating property. However cellosolves such as methylcellosolve, ethylcellosolve, methylcellosolve acetate and ethylcelosolve acetate, esters such as butyl acetate and amyl acetate, high polar solvents such as dimethylformamide, dimethylacetamide, N-methylpyrrolidone a mixture thereof and a mixed solvent prepared by adding an aromatic hydrocarbon thereto may be mentioned.

As the resin of cyclized rubber, those which are obtained by partially cyclizing poly(cis-isoprene) are preferably used. As the photosensitizer of azide, for instance, the compounds disclosed in J. Koser, "Light-sensitive Systems", John Wiley & Sons, Inc., 330 - 336 may be mentioned. Of these, 2,6-di(4'-azidobenzal)-4-methylcyclohexanone is preferred. Usually these components are used by dissolving them in a suitable solvent. There is no limit on the solvent so long as it has a sufficient dissolving power for the photosensitiser and resin and gives a favorable coating property. However, aromatic hydrocarbons such as xylene, toluene and methylbenzene are preferably used.

The photo-resist of the present invention may be used as a mask in ion implantation in a manner, for example, as set forth below. The photo-resist of the present invention is applied on a substrate to be implanted with ions in a thickness of 0.2 to 2.5 µm by a spin-coating method. The applied photo-resist is then patterned by exposure to light and development. The substrate having the patterned photo-resist thereon is subjected to ion implantation after exposing the part to be ion-implanted. After ion implantation, the remaining photo-resist on the substrate is removed by a photo-resist remover or by plasma incineration, thereby obtaining a substrate implanted with ions.

It has been known that in the case of carrying out an ion implantation to an insulating body with a large electric current, the uniformity of the implantation is deteriorated by electrification of the insulating body. Ordinarily, in the case when the ion implantation is carried out using a photo-resist as the mask, since the photo-resist is an insulating body, there is a difference in the implantation amount between the vicinity of the center part and the peripheral parts of the wafer. Accordingly, the amount of good products is reduced.

However, by using the photo-resist of the present invention, electrification is prevented and no difference in the implantation amount occurs. the uniformity of ion implantation (σ/x̅) as defined below is preferably not greater than 50%, more preferably not greater than 30%.

The present invention is now further explained in the following Examples.

### EXAMPLE 1:

Into 70.4 g of ethylcellosolve acetate, 22.2 g of a novolac resin obtained by polycondensing a mixture of m-cresol, p-cresol and 2,5-xylenol (in a molar ratio of 3:4:3) with formaldehyde using oxalic acid as a catalyst and 7.4 g of 1,2-naphthoquinonediazide-5-sulfonic ester of 2,3,4,4'-tetrahydroxybenzophenone (esterification : 75 %) were dissolved. Into this solution, 0.296 g of TTF-TCNQ complex was dissolved, and the thus formed solution was filtered through a membrane filter (0.2 µ pore diameter, made by MILLIPORE Co.) to prepare an antistatic photo-resist.

Evaluation of the effectiveness of the photo-resist was carried out by the following method.

After applying the photo-resist on a quartz wafer by a spin-coating method, prebaking the coated wafer for 1 minute at 90°C, and then patterning the photo-resist, ion implantation was carried out by a rotation disk-type ion implantation apparatus with a large electric current (made by NIHON SHINKU Co., Ltd.) under the conditions: As⁺ 4 x 10¹⁵ cm⁻², current value 2 mA and accelerating energy 50 eV. The uniformity of the ion implantation was evaluated by an ion-scanner (made by ION-SCAN Co., Ltd.). The surface resistance of the photo-resist was also measured.

The results are shown in Table 1.

### EXAMPLE 2:

In the same manner as in Example 1 except for using p-diethylaminobenzaldehyde diphenylhydrazone (ionization potential : 6.55eV) instead of the TTF-TCNQ complex of Example 1 an antistatic photo-resist was prepared. Evaluation of the photo-resist was carried out in the same manner as in Example 1. The results are shown in Table 1.

### EXAMPLE 3:

In the same manner as in Example 1 except for using "HI-BORON SC" (an organic semiconductor, made by BORON INTERNATIONAL Co., Ltd.) instead of the TTF-TCNQ complex, an antistatic photo-resist was prepared. Evaluation of the photo-resist was carried out in the same manner as in Example 1. The results are shown in Table 1.

### COMPARATIVE EXAMPLE:

The evaluation of AZ-1350 (a photo-resist of a novolac resin made by HOECHST) was carried out in the same manner as in Example 1. The results are shown in Table 1.

**TABLE 1**

| | Uniformity of ion implantation σ /X̅ ¹⁾ | Surface resistance after ion implantation (Ω) |
|---|---|---|
| Example 1 | 24.7 % | 1.0 x 10¹⁰ |
| Example 2 | 20.9 % | 1.0 x 10¹⁰ |
| Example 3 | 15.9 % | 1.0 x 10¹⁰ |
| Comparative Example | > 100 % | 1.9 x 10¹⁰ |
| Note: X̅ is the mean value of the amount of implanted ions with respect to the whole surface of the wafer, and σ is the variance. Uniformity of ion implantation is better for smaller values of σ/X̅. | | |

## Claims

1. A photo-resist for use as a mask in ion implantation of a semiconductor substrate, which comprises an antistatically effective amount of an anti-static agent, said anti-static agent being:
i) a substance having an ionisation potential of not larger than 7.5 eV and being ethylcarbazole, or a derivative of pyrazoline, oxadiazole or hydrazone or p-bis(dimethylamino)benzene; or
ii) an organic conductor of a charge-transfer complex type comprising a donor which is tetrathiafulvalene,a condensed-polynuclear aromatic compound, an aromatic amine selected from p-diaminobenzene, 4,4'-bis(dimethylamino)biphenyl and naphthylamine, or dibenzopyrazine and an acceptor which is a polycyano compound, a quinone derivative or a polynitro compound.

2. A photo-resist according to claim 1, wherein said antistatic agent is the derivative of hydrazone or p-bis(dimethylamino)benzene.

3. A photo-resist according to claim 1, wherein said antistatic agent is an organic conductor of a charge-transfer complex type comprising a donor which is tetrathiafulvalene, chrysene, pyrene, p-diaminobenzene, 4,4'-bis (dimethylamino)biphenyl, naphthylamine or dibenzopyrazine and an acceptor which is tetracyanoquinodimethane, tetracyanoethane, chloranil, bromanil, fluoranil, dicyanodichloroquinone or trinitrobenzene.

4. A photo-resist according to Class 3, wherein the donor is tetrathiafulvalene and the acceptor is tetracyanoquinodimethane.

5. A photo-resist according to any one of the preceding claims, wherein the amount of said antistatic agent is 0.1 to 15 wt% based on the solid content of said photo resist (3).

6. A method of producing a semiconductor substrate (1) implanted with ions (4) by applying a photo-resist (3) on to a semiconductor substrate (1), patterning the photo-resist (3) and effecting ion implantation, wherein the photo-resist (3) is a photo-resist (3) as claimed in any one of claims 1 to 5.

## Patentansprüche

1. Photolack zur Verwendung als Maske bei der Ionen-Implantation in ein Halbleitersubstrat mit einem Gehalt an einer antistatisch wirksamen Menge eines Antistatik-Mittels,
**dadurch gekennzeichnet,**
daß es sich bei dem Antistatik-Mittel um
i) eine Substanz mit einem Ionisationspotential Von nicht mehr als 7,5 eV handelt, die Ethylcarbazol oder ein Derivat von Pyrazolin, Oxadiazol oder Hydrazon oder p-Bis(dimethylamino)benzol ist,
oder
ii) einen organischen Leiter vom Ladungstransfer-Komplextyp handelt, der als Donor Tetrathiafulvalen, eine kondensiert-mehrkernige aromatische Verbindung, ein aromatisches Amin ausgewählt aus p-Diaminobenzol, 4,4'-Bis(dimethylamino)biphenyl und Naphtylamin, oder Dibenzopyrazin und als Akzeptor eine Polycyanoverbindung, ein Chinonderivat oder eine Polynitroverbindung enthält.

2. Photolack gemäß Anspruch 1, wobei das Antistatik-Mittel ein Derivat von Hydrazon oder p-Bis(dimethylamino)benzol ist.

3. Photolack gemäß Anspruch 1, wobei das Antistatik-Mittel ein organischer )Leiter vom Ladungstransfer-Komplextyp ist, bei dem als Donor Tetrathiafulvalen, Chrysen, Pyren, p-Diaminobenzol, 4,4'-Bis(dimethylamino)biphenyl, Naphthylamin oder Dibenzopyrazin und als Akzeptor Tetracyanochinodimethan, Tetracyanoethan, Chloranil, Bromanil, Fluoranil, Dicyanodichlorochinon oder Trinitrobenzol vorhanden ist.

4. Photolack gemäß Anspruch 3, wobei der Donor Tetrathiafulvalen und der Akzeptor Tetracyanochinodimethan ist.

5. Photolack gemäß einem der vorangehenden Ansprüche, wobei der Gehalt an dem Antistatik-Mittel 0,1 bis 15 Gew.-%, bezogen auf den Festgehalt des Photolacks (3) beträgt.

6. Verfahren zur Herstellung eines Halbleitersubstrats (1) mit implantierten Ionen (4) durch Aufbringen eines Photolacks (3) auf ein Halbleitersubstrat (1), Musterung des Photolacks (3) und Durchführung der Ionen-Implantation, wobei der Photolack (3) ein solcher gemaß einem der Ansprüche 1 bis 5 ist.

## Revendications

1. Photorésist susceptible d'être utilisé comme masque au cours de l'implantation d'ions dans un substrat semi-conducteur, qui comprend une quantité efficace en terme antistatique d'un agent antistatique, ledit agent antistatique étant :
i) une substance ayant un potentiel d'ionisation qui n'est pas supérieur à 7,5 eV et qui est constituée d'éthylcarbazole ou d'un dérivé de la pyrazoline, de l'oxadiazole ou de l'hydrazone ou encore du p-bis(diméthylamino)benzène ; ou
ii) un conducteur organique d'un type de complexe à transfert de charge comprenant un donneur qui est le tétrathiafulvalène, un composé aromatique polynucléaire condensé, une amine aromatique choisie entre le p-diaminobenzène, le 4,4'-bis(diméthylamino)biphényle et la naphtylamine, ou la dibenzopyrazine et un accepteur qui est un composé polycyano, un dérivé de quinone ou un composé polynitro.

2. Photorésist selon la revendication 1, dans lequel ledit agent antistatique est le dérivé d'hydrazone ou de p-bis(diméthylamino)benzène.

3. Photorésist selon la revendication 1, dans lequel ledit agent antistatique est un conducteur organique d'un type de complexe à transfert de charge comprenant un donneur qui est le tétrathiafulvalène, le chrysène, le pyrène, le p-diaminobenzène, le 4,4'-bis (diméthylamino)biphényle, la naphtylamine ou la dibenzopyrazine, et un accepteur qui est le tétracyanoquinodiméthane, le tétracyanoéthane, le chloranil, le bromanil, le fluroanil, la dicyanodichloroquinone ou le trinitrobenzène.

4. Photorésist selon la revendication 3, dans lequel le donneur est le tétrathiafulvalène et l'accepteur est le tétracyanoquinodiméthane.

5. Photorésist selon l'une quelconque des revendications précédentes, dans lequel la quantité dudit agent antistatique est de 0,1 à 15 % en poids sur base de la teneur en solides dudit photorésist (3).

6. Procédé de production d'un substrat semi-conducteur (1) avec des ions (4) implantés par application d'un photorésist (3) sur un substrat semi-conducteur (1) application du motif sur le photo-résist (3) et réalisation de l'implantation ionique, le photorésist étant un photorésist (3) selon l'une quelconque des revendications 1 à 5.
